# EUROPEAN PATENT APPLICATION

(11) **EP 0 827 155 A2**
(43) Date of publication of application: **04.03.1998**
(21) Application number: 97114589.1
(22) Date of filing: 22.08.1997
(51) Int. Cl.: G11C 15/04

(54) **Associative memory having precharge circuit for precharging coincidence detection signal line**

(30) Priority: 23.08.1996 JP 222241/96
(71) Applicant: NEC CORPORATION, Tokyo (JP)
(72) Inventor: Okita, Munehisa, NEC IC Microcomputer Syst. Ltd., Kawasaki-shi, Kanagawa (JP)
(74) Representative: Betten & Resch

(57) **Abstract**

An associative memory with reduced electric consumption in coincidence detection, increased detection speed, and reduced erroneous operation. A word-data coincidence detector has a transfer gate group having an N serially-connected transistors N61 to N6N each of which includes a gate to input bit-data coincidence-detection information and one end to input potential of a power source VDD, and each of which outputs the word-data coincidence-detection information, and a transistor N10 which connect/disconnect the other end of the transistor N61 to ground potential, in response to control of an inverting pre-charge signal line PC2.

## Description

### BACKGROUND OF THE INVENTION

### Field of The Invention

This invention relates to an associative memory and, more particularly to an associative memory having an associative memory having a precharge circuit for precharging a coincidence-detection signal line.

### Description of Related Art

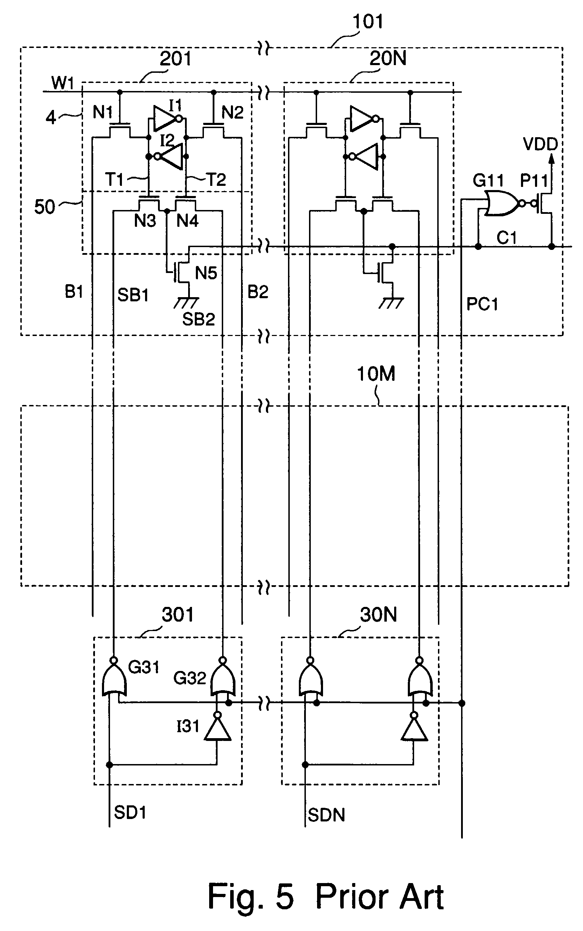

A first conventional and general associative memory is shown in Fig. 5. In Fig. 5, the first associative memory comprises M (M is an integer "2" or greater; usually "32" or "64") word blocks 101 to 10M, each having N (N is an integer "2" or greater)-bit associative memory cells 201 to 20N each corresponding to one word, and retrieval-data input circuits 301 to 30N corresponding to the respective N bits.

The associative memory cells 201 to 20N (hereinafter represented by cell 201) comprise a memory circuit 4 for storing data, and a comparator 50 which compares stored data with retrieval data and detects coincidence or non-coincidence of these data.

The memory circuit 4 comprises loop-connected inverters I1 and I2 constituting a 1-bit flip-flop memory device, and N-channel transistors N1 and N2 respectively having a gate connected to a word line W1, a source and a drain one of which connected to a complementary storage data-bit line (B1/B2), for controlling data to be stored in the memory circuit. More specifically, in the transistor N1, the source or drain is connected to the storage data-bit line B1, while in the transistor N2, the source of drain is connected to the storage data-bit line B2.

The comparator 50 comprises a transistor N3 having a gate connected to a connection point T1 as a common connection point to an input terminal of the inverter I1 and an output terminal of the inverter I2, a transistor N4 having a gate connected to a connection point T2 as a common connection point to an input terminal of the inverter I2 and an output terminal of the inverter I1, and a transistor N5 having a gate connected to a connection point T3 as a common connection point to the source or drain of the transistor N3 and the source or drain of the transistor N4, and a source grounded.

The other electrode (source or drain) of the transistor N1 and that of the transistor N2 are respectively connected to the connection points T1 and T2, thus constituting transfer gates for the storage data-bit lines B1 and B2. The other electrode of the transistor N3 and that of the transistor N4 are respectively connected to complementary retrieval data-bit lines SB1 and SB2, thus constituting transfer gates for the connection points T1 and T2.

The associative memory cells 201 to 20N are arrayed in a horizontal direction in Fig. 5, and commonly connected to the word line W1, constituting a word block 101. The word block 101 comprises a coincidence-detection signal line C1 commonly connecting the drains of the transistors N51 to N5N of the associative memory cells 201 to 20N, a pre-charge signal line PC1, a NOR gate G11 which inputs output from the coincidence-detection signal line C1 and output from the pre-charge signal line PC1, and a P-channel transistor P11 having a gate to receive output from the NOR gate G11, a source connected to a power source VDD, and a drain connected to the coincidence-detection signal line C1, thus constituting a latch circuit.

The word blocks 101 to 10M are arrayed in a vertical direction in Fig. 5. The storage data-bit lines B1 and B2, the retrieval data-bit lines SB1 and SB2 and the pre-charge signal line PC1 are commonly connected through the respective word blocks.

The retrieval-data input circuits 301 to 30N (hereinafter represented by circuit 301) comprise an inverter 131 which inputs data from a retrieval data line SD1, and NOR gates G31 and G32. The NOR gate G31 has an input terminal connected to output from the retrieval data line SD1, and the NOR gate G32 has an input terminal connected to output from the inverter I31 and output from the retrieval data line SD1. NOR gates G31 and G32 respectively have an another input terminal connected to the pre-charge signal line PC1. NOR gate G31 has an output terminal connected to the retrieval data-bit line SB1, and NOR gate G32 has an output terminal connected to the retrieval data-bit line SB2.

Next, the operation of the first conventional associative memory will be described with reference to Fig. 5. First, the pre-charge signal line PC1 is set to a logic level "1", so that output from the NOR gate G11 is at a logic level "0", the transistor P11 is turned ON, and at the same time, the retrieval data-bit lines SB1 and SB2 as outputs from the NOR gates G31 and G32 are at the logic level "0". Then one of the transistors N3 and N4 of the associative memory cell 201 becomes ON in accordance with data stored at the inverters I1 and I2, and the connection point T3, i.e., the logic level of the gate of the transistor N5 becomes "0". The transistor N5 becomes OFF, and the coincidence-detection signal line C1 is pre-charged to the logic level "1". When the logic level of the coincidence-detection signal line C1 becomes "0", the pre-charge period expires, then coincidence detection operation is performed.

Next, the coincidence detection operation in case of coincidence and non-coincidence will be described. First, the coincidence detection operation will be described. In this case, data stored in the associative memory cell 20 and retrieval data sd are compared. For example, data at the logic level "1" is stored at the connection point T1, and data at the logic level "0" is stored at the connection point T2, and the retrieval data sd at the logic level "1" is inputted. If retrieval data bits sb1 and sb2 respectively have the logic levels "0" and "1", the transistor N3 becomes ON, the transistor N4 becomes OFF, and the logic level "0" of the retrieval data-bit line SB1 is transmitted to the gate of the transistor N5, thus transistor N5 becomes OFF. Similarly, when data at the logic level "0" is stored at the connection point T1, data at the logic level "1" is stored at the connection point T2, and the retrieval data sd at the logic level "1" is inputted, the transistor N5 becomes OFF.

If coincidence has been detected at all the associative memory cells 201 to 20N constituting the word block 101, all the transistors N51 to N5N become OFF, then the coincidence-detection signal line C1 maintains the logic level "1" charged during the pre-charge period without discharging. This is the coincidence detection operation.

Next, the non-coincidence detection operation will be described. First, data stored in the associative memory cell 20 and the retrieval data sd are compared. Similar to the above case, data at the logic level "1" is stored at the connection point T1, and data at the logic level "0" is stored at the connection point T2, however, in this case, the retrieval data at the logic level "0" is inputted. If the retrieval data bits sb1 and sb2 are respectively at the logic levels "1" and "0", the transistor N3 becomes ON, the transistor N4 becomes OFF, and the logic level "1" of the retrieval data-bit line SB1 is transmitted to the gate of the transistor N5, thus transistor N5 becomes ON. Similarly, when data at the logic level "0" is stored at the connection point T1, data at the logic level "1" is stored at the connection point T2, and the retrieval data sd at the logic level "1" is inputted, the transistor N5 becomes ON.

If non-coincidence has been detected at any of the associative memory cells 201 to 20N constituting the word block 101, any of the transistors N51 to N5N becomes ON, therefore the logic level of the coincidence-detection signal line C1 becomes "0" from the logic level "1" by discharging electrical energy charged during the pre-charge period. This is the non-coincidence detection operation.

As described above, the coincidence-detection is simultaneously performed at the N associative memory cells 201 to 20N constituting a word block 101. The logic of the coincidence-detection signal line C1 is "coincident" if coincidence has been detected at all the bits, while "non-coincident" if non-coincidence has been detected at least at one bit. Further, these operations are simultaneously performed at all the word blocks 101 to 10M.

However, in associative memories of this type, electric power is consumed due to pre-charge and discharge in case of detection of non-coincidence. Generally, in case of non-coincidence, coincidence is detected at only one of the M word blocks, and non-coincidence is detected at the other M-1 word blocks. Therefore, electric power is expended at the most of the word blocks (the M-1 word blocks), which increases the electric consumption of the entire associative memory.

For example, in a case where the power of the pre-charge current and discharge current is 5 mW, and the associative memory is constituted with 64 word blocks (M = 64), electric power is consumed at the 63 word blocks, and the total electric consumption is 315 mW.

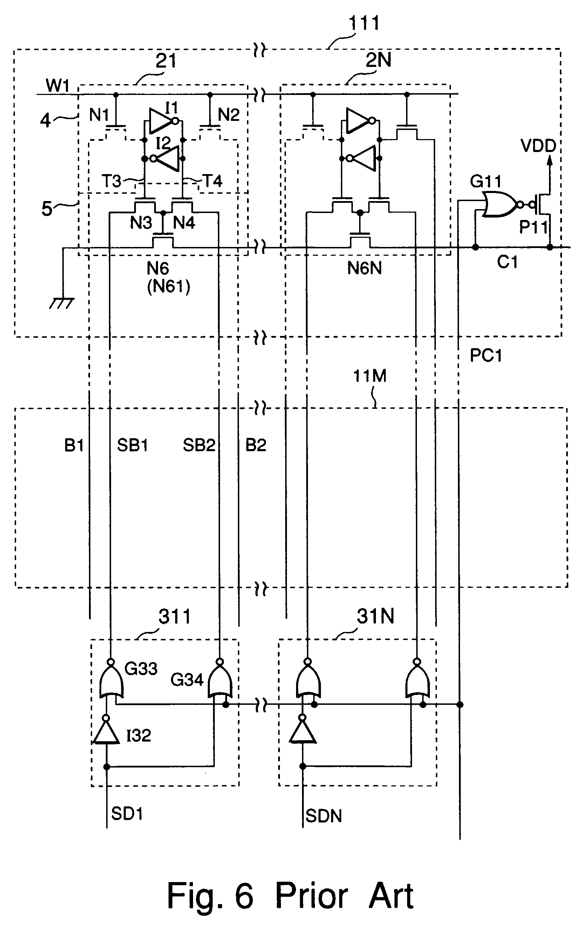

Fig. 6 is a block diagram showing a second conventional associative memory which solves this problem, disclosed in Japanese Patent Application Laid-Open No. 6-12883. In Fig. 6, elements corresponding to those in Fig. 5 have the same reference numerals. The difference from the first conventional associative memory in Fig. 5 is that a word block 111 comprises memory cells 21 to 2N each having a comparator 5 including an N-channel transistor N6 having a gate connected to the connection point T3, instead of the associative memory cells 201 to 20N, and retrieval-data input circuits 311 to 31N (hereinafter represented by circuit 311) each having an inverter I32, which inputs output from the retrieval data line SD1, and NOR gates G33 and G34, instead of the retrieval-data input circuits 301 to 30N. The NOR gate G33 has an input terminal connected to output from an inverter I32 and output from the retrieval data line SD1, and the NOR gate G34 has an input terminal connected to output from the retrieval data line SD1. The NOR gates G33 and G34 respectively have an another input terminal connected to the pre-charge signal line PC1. The NOR gate G33 has an output terminal connected to the retrieval data-bit line SB1, and the NOR gate G34 has an output terminal connected to the retrieval data-bit line SB2.

In the memory cell 2i (i is integer "1" to "N"), the transistor N6i has a drain and a source one of which serially connected to one of electrodes of the transistor N6i + 1 of the adjacent associative memory cell 2i + 1. Note that the other electrode of the uppermost transistor N6N is connected to the pre-charge signal line PC1, while the other electrode of the lowest transistor N61 is connected to a ground potential GND.

The transistors N3, N4, N6, and the retrieval data-bit lines SB1, SB2 constitute a comparator.

Next, the operation of the second conventional associative memory will be described with reference to Fig. 6. First, similar to the first associative memory, the pre-charge signal line PC1 is set to the logic level "1", whereby the coincidence-detection signal line C1 is pre-charged to the logic level "1". When the logic level of the pre-charge signal line PC1 becomes "0", the pre-charge period expires, and coincidence detection operation is performed.

Next, the coincidence detection operation in case of coincidence and non-coincidence will be described. First, the coincidence detection operation will be described. In this case, data stored in the associative memory cell 2 and retrieval data sd are compared. Similar to the first conventional associative memory, data at the logic level "1" is stored at the connection point T1, and data at the logic level "0" is stored at the connection point T2, and the retrieval data sd at the logic level "1" is inputted. However, if the retrieval data bits sb1 and sb2 respectively have the logic levels "1" and "0", the transistor N3 becomes ON, the transistor N4 becomes OFF, and the logic level "1" of the retrieval data-bit line SB1 is transmitted to the gate of the transistor N6, then the transistor N6 becomes ON. Similarly, when data at the logic level "0" is stored at the connection point T1, data at the logic level "1" is stored at the connection point T2, and the retrieval data sd at the logic level "1" is inputted, thus the transistor N6 becomes ON.

If coincidence has been detected at all the associative memory cells 21 to 2N constituting the word block 111, all the transistors N61 to N6N become ON, therefore the logic level of the coincidence-detection signal line C1 becomes "0" by discharging electrical energy charged during the pre-charge period. This is the coincidence detection operation.

Next, the non-coincidence detection operation will be described. First, data stored in the associative memory cell 2 and the retrieval data sd are compared. Similar to the above case, data at the logic level "1" is stored at the connection point T1, and data at the logic level "0" is stored at the connection point T2, however, in this case, the retrieval data at the logic level "0" is inputted. Then, the transistor N3 becomes ON, the transistor N4 becomes OFF, and the logic level "0" of the retrieval data-bit line SB1 is transmitted to the gate of the transistor N6, thus transistor N6 becomes OFF. Similarly, when data at the logic level "0" is stored at the connection point T1, data at the logic level "1" is stored at the connection point T2, and the retrieval data sd at the logic level "1" is inputted, thus the transistor N6 becomes OFF.

If non-coincidence has been detected at any of the associative memory cells 21 to 2N constituting the word block 111, any of the transistors N61 to N6N becomes OFF, therefore the coincidence-detection signal line C1 maintains the logic level "1" without discharging electrical energy charged during the pre-charge period. This is the non-coincidence detection operation.

In the second conventional associative memory, electric power is consumed depending on pre-charge and discharge in coincidence detection operation, i.e., electric power is consumed at only one of the M word blocks. This reduces the electric consumption of the entire memory.

However, in the second conventional associative memory, as the coincidence detection operation is discharging from the pre-charged logic level "1" on the coincidence-detection signal line CP1 in correspondence with ON states of the serially-connected transistors N61 and N6N, as the number of bits N becomes greater, the number of transistor N6 becomes greater, which increases delay time, and disturbs fast operation.

Further, although the non-coincidence is detected by the OFF state of any of the transistors N61 to N6N, the logic level of the coincidence-detection signal line C1, to be "non-coincident" level, erroneously becomes "coincident" level depending on a combination of "non-coincident" bits, i.e., the combination of ON and OFF bits.

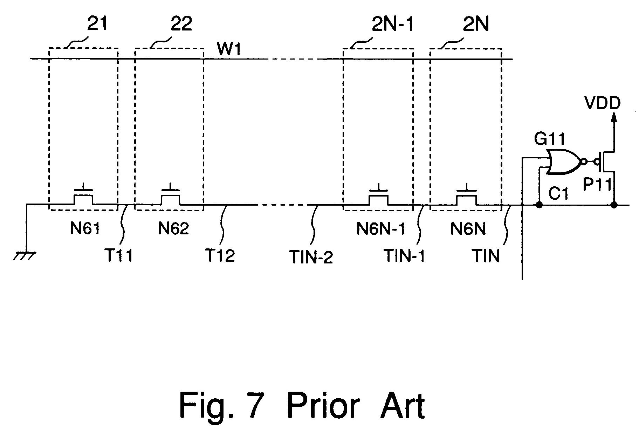

Next, such erroneous operation will be described with reference to Fig. 7 which is a block diagram for explaining a coincidence-signal detection function of the word block 11 of the second conventional associative memory. Fig. 7 shows the associative memory cells 21 to 2N, the transistors N61 to N6N, and the coincidence-detection signal line C1. In Fig. 7, the associative memory cell 21 indicates "non-coincident", while the associative memory cells 22 to 2N indicate "coincident".

As shown in Fig. 7, if the memory cell 21, farthest from the coincidence-detection signal line C1, is OFF indicating "non-coincident", while the rest of the associative memory cells 22 to 2N are ON indicating "coincident", upon coincidence-detection operation after the pre-charge period, the logic level "1" is changed due to wiring capacitance and diffusion capacitance applied to connection points T11 to T1N, i.e., voltage-divided, thus indicating "non-coincident". This level down has been caused since during the pre-charge period, the transistors N61 to N6N of the associative memory cells 21 to 2N are OFF, and the pre-charge operation is not performed from the coincidence-detection signal line C1 to the connection points T11 to T1N separated by the transistors N61 to N6N. In this manner, the logic level initially indicating "non-coincident" comes to indicate "coincident", thus causing erroneous operation.

Further, in the above example as one of the combinations of "coincident" and "non-coincident", erroneous operation occurs when the wiring capacitance and the diffusion capacitance voltage-dividing the pre-charge level are maximum; however, the erroneous operation also occurs, as in another combination, when only the associative memory cell 2N indicates "coincident" but the other associative memory cells 21 to 2N-1 indicate "non-coincident". In this case, when the pre-charge period has expired, the logic level "1" indicating "non-coincident" becomes "coincident" due to level down caused by the wiring capacitance and the diffusion capacitance applied to the connection point TN-1. If the associative memory cell 2N indicates "non-coincident" and the transistor N6N is OFF, the pre-charge logic level "1" of the coincidence-detection signal C1 is maintained without level down, thus indicates normal "non-coincident" state.

It is understood from the above facts that the occurrence/absence of erroneous operation is determined by "coincident"/"non-coincident" state of the associative memory cell 2N, closest to the coincidence-detection signal line C1. In other words, the erroneous operation occurs at 50% which is the probability of "coincident"/"non-coincident" status of the associative memory cell 2N.

In the above-described first conventional associative memory, upon coincidence detection, electric power is consumed due to pre-charge and discharge upon non-coincidence detection. When non-coincidence is detected normally, coincidence has been detected at only one of the plurality of word blocks while non-coincidence has been detected at the other word blocks. This increases electric consumption of the entire associative memory.

In the second conventional associative memory, coincidence detection operation is discharging from the pre-charged logic level on the coincidence-detection signal line C1 due to switching operation of the serially-connected transistors. As the number of bits becomes greater, the number of the serially-connected transistors becomes greater. This increases delay time, and thus lowers coincidence detection speed. Further, as the serially-connected transistors are OFF during the pre-charge period, the pre-charge operation is not performed from the coincidence-detection signal line C1 to the connection points separated by the serially-connected transistors. Therefore, upon coincidence detection after the pre-charge period, the pre-charged level changes due to the wiring capacitance and the diffusion capacitance applied to the respective connection points. The level down of the pre-charged logic level causes erroneous operation at 50% probability depending on the scale of the circuit.

### SUMMARY OF THE INVENTION

The present invention has been made to solve the above drawbacks, and has its object to provide an associative memory, which is capable of fast operation, and in which electric consumption in coincidence detection is reduced, and factors in erroneous operation are removed.

According to the present invention, the foregoing object is attained by providing an associative memory comprising:
a first number of associative memory cells each including:
   a memory circuit which connects first and second terminals of a flip-flop memory device to complementary data bit lines via first and second transfer gates, and controls input/output of storage data, in response to control of word line connected to respective control gates of said first and second transfer gates; and a bit-data coincidence detector which connects respective said first and second terminals of said memory device via third and fourth transfer gates, detects coincidence between said storage data and retrieval data in correspondence with control of a coincidence-detection control signal, and outputs bit-data coincidence-detection information; and a second number of word blocks, arranged in a column direction, each having a word-data coincidence detector, including said plurality of associated memories arranged in a row direction, which integrates said bit-data coincidence-detection information in word units and outputs word-data coincidence-detection information, wherein said word-data coincidence detector includes: a transfer gate group having said first number of serially-connected fifth transfer gates, each having a control gate to input said first number of bit-data coincidence-detection information of said word-data coincidence detectors, and one end connected to a first potential, wherein each of said transfer gates outputs said word-data coincidence-detection information; and switch circuits which connect or disconnect another end of each of said transfer gate with a second potential, in correspondence with control of said coincidence-detection control signal.

Other features and advantages of the present invention will be apparent from the following description taken in conjunction with the accompanying drawings, in which like reference characters designate the same name or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a block diagram showing an associative memory according to a first embodiment of the present invention;
Fig. 2 is a block diagram showing an associative memory cell of the associative memory, according to a second embodiment of the present invention;
Fig. 3 is a block diagram showing the associative memory cell of the associative memory, according to a third embodiment of the present invention;
Fig. 4 is a block diagram showing the associative memory cell of the associative memory, according to a fourth embodiment of the present invention;
Fig. 5 is a block diagram showing an example of the first conventional associative memory;
Fig. 6 is a block diagram showing an example of the second conventional associative memory; and
Fig. 7 is a block diagram for explaining the factor in erroneous operation of the second conventional associative memory.

### DETAILED DESCRIPTION OF THE PREFERRED EMBODIMENTS

Preferred embodiments of the present invention will now be described in detail in accordance with the accompanying drawings.

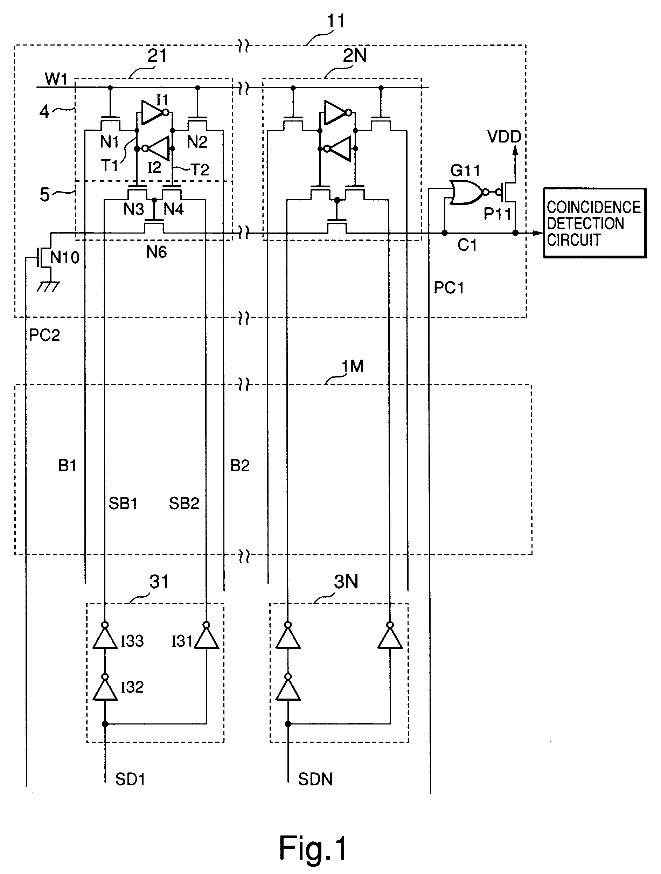

Fig. 1 is a block diagram showing an associative memory according to a first embodiment of the present invention. In Fig. 1, elements corresponding to those in Fig. 6 have the same reference numerals. The associative memory comprises M (M is an integer "2" or greater; usually 32 or 64) word blocks 11 to 1M each having N (N is an integer "2" or greater)-bit associative memory cells 21 to 2N each including the memory circuit 4 and the comparator 5 corresponding to the comparator and the memory circuit of the second conventional associative memory, corresponding to one word, and retrieval-data input circuits 31 to 3N corresponding to the respective N bits.

The word blocks 11 to 1N are arrayed in the horizontal direction. The word block 1i (i is integer "1" to "M") comprises the memory cells 21 to 2N corresponding to those of the second conventional associative memory, which are commonly connected to the word line W1 and which constitute one word block, the coincidence-detection signal line C1, the pre-charge signal line PC1, the NOR gate G11 which inputs output from the coincidence-detection signal line C1 and the pre-charge signal line PC1, and the P-channel transistor P11 having a gate which inputs output from the NOR gate G11, a source connected to the power source VDD and a drain connected to the coincidence-detection signal line C1, thus constituting a latch circuit, and an N-channel transistor N10 having a drain connected to one electrode of the lowest transistor N61 of the initial memory cell 21, a gate connected to an inverting pre-charge signal line PC2 and a source connected to the ground potential.

In the memory cell 2i (i is integer "1" to "N"), the transistor N6i has a drain and a source one of which serially connected to one of electrodes of the transistor N6i + 1 of the adjacent associative memory cell 2i + 1. Note that the other electrode of the uppermost transistor N6N is connected to the pre-charge signal line PC1, while the other electrode of the lowest transistor N61 is connected to the drain of the transistor N10.

The retrieval-data input circuits 31 to 3N comprise an inverter I31 which inputs output from the retrieval data line SD1 and outputs data from its output terminal to the retrieval data-bit line SB2, and serially-connected inverters I32 and I33, which respectively input output from the retrieval data line SD1 and output data from their output terminals to the inverting retrieval data-bit line SB1.

The transistors N3, N4, N6 and the retrieval data-bit lines SB1, SB2 constitute the comparator.

Next, the operation of the first embodiment will be described with reference to Fig. 1. First, the pre-charge signal line PC1 is set to the logic level "1". Then similar to the first and second conventional associative memories, the logic level of output from the NOR gate G11 becomes "0", and the transistor P11 becomes ON. Further, the logic level of the inverting pre-charge signal line PCB1 becomes "0", and the transistor N10 becomes ON. Thus, the coincidence-detection signal line C1 is pre-charged to the logic level "1". At the same time, the logic levels of the retrieval data lines SD1 to SDN are settled, then the associative memory cells 21 to 2N performs coincidence detection operation.

Next, the coincidence detection operation in case of coincidence and non-coincidence will be described. First, the coincidence detection operation will be described. In this case, data stored in the associative memory cell 2 and retrieval data sd of the retrieval data line SD1 are compared. Similar to the conventional associative memories, data at the logic level "1" is stored at the connection point T1, data at the logic level "0" is stored at the connection point T2, and the retrieval data sd at the logic level "1" is inputted. If the retrieval data-bit lines SB1 and SB2 respectively have the logic levels "1" and "0", the transistor N3 becomes ON, the transistor N4 becomes OFF, and the logic level "1" of the retrieval data-bit line SB1 is transmitted to the gate of the transistor N6, thus transistor N6 becomes ON. Similarly, when data at the logic level "0" is stored at the connection point T1, data at the logic level "1" is stored at the connection point T2, and the retrieval data sd at the logic level "1" is inputted, the transistor N6 becomes ON.

If coincidence has been detected at all the associative memory cells 21 to 2N constituting the word block 11, all the transistors N61 to N6N connected the coincidence-detection signal line C1 become ON, therefore the pre-charge operation is performed from the coincidence-detection signal line C1 via the transistors N61 to N6N to the drain of the transistor N10.

Next, the non-coincidence detection operation will be described. First, data stored in the associative memory cell 2 and the retrieval data sd are compared. Similar to the above case, data at the logic level "1" is stored at the connection point T1, data at the logic level "0" is stored at the connection point T2, however, in this case, the retrieval data sd at the logic level "0" is inputted. The transistor N3 becomes ON, the transistor N4 becomes OFF, and the logic level "0" of the retrieval data-bit line SB1 is transmitted to the gate of the transistor N6, thus transistor N6 becomes OFF. Similarly, when data at the logic level "0" is stored at the connection point T1, data at the logic level "1" is stored at the connection point T2, and the retrieval data sd at the logic level "1" is inputted, the transistor N6 becomes OFF.

If non-coincidence has been detected at any of the associative memory cells 21 to 2N constituting the word block 11, any of the transistors N61 to N6N becomes OFF, then pre-charge operation is performed from the coincidence-detection signal line C1 to the serial connection point of the transistor N6K (K is an integer "1" to "N") which is ON as "coincident". Next, the pre-charge period expires when the logic level of the pre-charge signal line C1 becomes "0", then coincidence detection is performed. First, as the logic level of the inverting pre-charge signal line PCB1 becomes "1", the transistor N10 becomes ON. In the coincidence detection operation, all the serially-connected transistors N61 to N6N are ON. The logic level "1" of the coincidence-detection signal line C1, charged during the pre-charge period, is pulled by the transistor N10, thus changes by discharge to the logic level "0" indicating "coincident". In the non-coincidence detection operation, any of the transistors N61 to N6N serially connected between the coincidence-detection signal line C1 and the transistor N10 is OFF. The coincidence-detection signal line C1 maintains the logic level "1" charged during the pre-charge period without discharging. This is non-coincidence detection operation.

The above-described coincidence detection operation is simultaneously performed at all the word blocks 11 to 1M. Normally, as described regarding the above conventional techniques, coincidence is detected at only one block, while non-coincidence is detected at the other M-1 word blocks.

According to the present embodiment, as electric power is consumed by pre-charge and discharge only in coincidence detection in which the number of operations is smaller than that in non-coincidence detection, the amount of electric consumption in coincidence detection operation can be reduced. For example, in a case where the power of the pre-charge current and discharge current in a word block is 5 mW, and the associative memory is constituted with 64 word blocks, similar to the conventional associative memory, electric power is consumed only at one word block, i.e., only 5mW power is consumed, while in the conventional associative memory, the electric power is consumed at the 63 word blocks and the total electric consumption is 315 mW. That is, in the associative memory of the present embodiment, 98% of the electric consumption in the conventional associative memory can be saved.

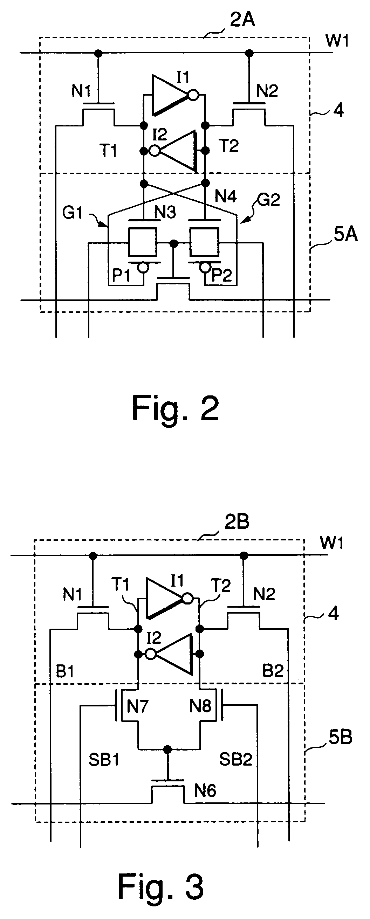

Fig. 2 is a block diagram showing associative memory cells 2A1 to 2AN (represented by cell 2A) according to a second embodiment of the present invention. In Fig. 2, elements corresponding to those in Fig. 1 have the same reference numerals. The difference from the associative memory cell 2 of the first embodiment is that the associative memory cell 2A of the second embodiment comprises a comparator 5A having P-channel transistors P1 and P2 which are respectively parallel-connected to the transistors N3 and N4, and which respectively constitute complementary transfer gates G1 and G2.

Next, the operation of the second embodiment will be described with reference to Fig. 2. In the above-described first embodiment, the N-channel transistors N3 and N4 are employed as transfer gates for transmitting the logic level "1"/"0" of the retrieval data-bit lines SB1 and SB2 to the gate of the transistor N6 constituting the switch circuit of the coincidence-detection signal line. The feature of the N-channel transistor is that when it is ON with the gate at the logic level "1", if the input of the drain/source electrode is at the logic level "0", the logic level "0" at the same potential is transmitted as output. However, if the input is at the logic level "1", potential which is lowered from that of the power source VDD at the logic level "1" by a threshold voltage Vtn of the transistor, is outputted. In this case, there is a possibility that sufficient potential to turn the transistor N6 ON cannot be obtained when the memory operates at a low voltage.

In the second embodiment, to solve the above problem, the complementary transfer gates G1 and G2 are employed as the transfer gates. First, if data having the logic levels "1" and "0" are stored at the connection points T1 and T2, and the logic level of the retrieval data-bit line SB1 is "1", the P-channel transistor P1 of the transfer gate G1 is ON. In this case, the potential of the power source VDD at the logic level "1" is transmitted to the gate of the transistor N6, therefore level down does not occur. Further, if the logic level of the retrieval data-bit line SB1 is "0", as the transistor N3 is ON, the ground potential at the logic level "0" is transmitted to the gate of the transistor N6.

As described above, the second embodiment enables stable operation even at low voltage by using the complementary transfer gate for transmitting the logic level of the retrieval data-bit line of the associative memory cell 2A.

Fig. 3 is a block diagram showing associative memory cells 2B1 to 2BN (represented by cell 2B) according to a third embodiment of the present invention. In Fig. 3, elements corresponding to those in Fig. 1 have the same reference numerals. The difference from the associative memory cell 2 of the first embodiment is that the associative memory cell 2B comprises a comparator 5B including an N-channel transistor N7 having a drain connected to the connection point T1, a source connected to the gate of the transistor N6 and a gate connected to the retrieval data-bit line SB1, and an N-channel transistor N8 having a drain connected to the connection point T2, a source connected to the gate of the transistor N6 and a gate connected to the retrieval data-bit line SB2, instead of the transistors N3 and N4 of the comparator 5.

Next, the operation of the third embodiment will be described with reference to Fig. 3. In the above-described second embodiment, the logic levels of the retrieval data-bit lines SB1 and SB2 are transmitted to the gate of the transistor N6 constructing the switch circuit of the coincidence-detection signal line via the two transfer gates constituting the comparator. The retrieval data-bit lines SB1 and SB2 are respectively parallel-connected to the transfer gates of M associative memory cells 2B of M word blocks. Accordingly, if the transfer gates, directly connected to the retrieval data-bit lines SB1 and SB2, on the connecting side, are OFF, the capacitance applied to the retrieval data-bit lines SB1 and SB2 is diffusion capacitance of the transistor of these transfer gates. When these transfer gates are ON, the capacitance applied to the retrieval data-bit lines SB1 and SB2 is the above diffusion capacitance of the transfer gates, in addition, the diffusion capacitance of the transistor on the opposite side and the diffusion capacitance of the other transfer gate connected to its connection point.

Further, ON/OFF of the two (referred to as "first" and "second" for the sake of explanation) transfer gates depends on data stored in the memory circuit. For example, if the stored data is at the logic level "1", the first transfer gate is ON, while if the stored data is at the logic level "0", the first transfer gate is OFF. That is, the number of ON transfer gates changes depending on the content of the data stored in the memory circuits of the M associative memory cells. That is, the capacitance applied to the retrieval data-bit lines changes depending on the content of the stored data in the M associative memory cells. Since this means that transmission delay varies in accordance with stored data in the associative memory cells of the respective bits, it is necessary to take these worst conditions into consideration for coincidence detection. This causes difficulty in designing of the associative memory.

In the third embodiment, the retrieval data-bit lines SB1 and SB2 are respectively connected to the gates of the transistors N7 and N8, and the gate of the transistor N6 is driven by the inverters I1 and I2 constituting the memory circuit. The respective load capacitances on the retrieval data-bit lines SB1 and SB2 correspond to those on the gates of the M transistors N7 and N8 connected to the retrieval data-bit lines SB1 and SB2, and there is no capacitance change depending on ON/OFF state. Therefore, it is not necessary to take delay time under the worst conditions due to the difference of the stored data into consideration. Thus, the associative memory can be easily designed.

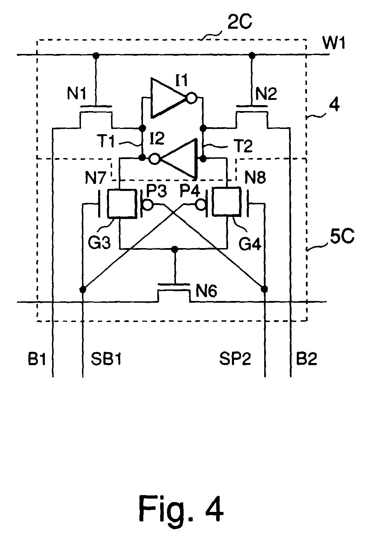

Fig. 4 is a block diagram showing associative memory cells 2C1 to 2CN (represented by cell 2C) according to a fourth embodiment of the present invention. In Fig. 4, elements corresponding to those in Fig. 3 have the same reference numerals. The difference from the associative memory cell 2B of the above-described third embodiment is that the associative memory cell 2C comprises a comparator 5C including P-channel transistors P3 and P4, which are respectively parallel-connected to the transistors N7 and N8 of the comparator and which respectively constitute complementary transfer gates G3 and G4.

Similar to the associative memory cell 2A of the second embodiment, the associative memory cell 2C has the complementary transfer gates G3 and G4 which transmit the logic level "1" and "0" to the gate of the transistor N6 constituting the switch circuit of the coincidence-detection signal line. This enables transmission of the logic level without level down.

In this manner, the fourth embodiment enables stable operation even at low voltage by using complementary transfer gates as transfer gates of the associative memory cell.

As described above, in the associative memory according to the present invention, a word-data coincidence circuit comprises a transfer gate group having serially-connected transfer gates, corresponding to the number of bits, respectively for inputting bit-data coincidence-detection information into respective control gates, and a switch circuit which turns ON/OFF the end of the transfer gate group to second potential in correspondence with control of a coincidence-detection control signal. This construction expends pre-charge and discharge current only in case of coincidence detection in which the number of operations is smaller than that in case of non-coincidence detection, therefore electric consumption in coincidence detection can be greatly reduced.

Further, during the pre-charge period, "coincident" or "non-coincident" states are settled within the associative memory cell, and after the pre-charge period, coincidence detection can be made only based on ON operation of the transistor. This increases the speed of coincidence detection.

For example, in the second conventional associative memory cell, coincidence detection is performed based on ON/OFF switching the pre-charge signal lines PC1, the nor gate G33, the transistor N3, and the transistor N6. On the other hand, in the present invention, coincidence detection is performed only based on ON/OFF switching the pre-charge signal line PC1 and then the transistor N10. Assuming that it takes 1 ns to pass one device, it takes 4 ns to pass four devices, however, in the associative memory of the present invention, it only takes 2 ns to pass the two devices. This attains 50% of increase in coincidence detection speed.

Further, "coincident"/"non-coincident" operation is settled within the associative memory during the pre-charge period, and even when coincidence is detected after the pre-charge period, the contact point at which the pre-charge has been performed is not changed, which does not cause level down of the logic level of the pre-charged coincidence-detection signal line. This attains 0% of the erroneous operation upon coincidence detection, and improves reliability of coincidence detection. The present invention is not limited to the above embodiments and various changes and modifications can be made within the spirit and scope of the present invention.

## Claims

1. An associative memory comprising:
a first number of associative memory cells each including: a memory circuit which connects first and second terminals of a flip-flop memory device to complementary data bit lines via first and second transfer gates, and controls input/output of storage data, in response to control of word line connected to respective control gates of said first and second transfer gates; and a bit-data coincidence detector which connects respective said first and second terminals of said memory device via third and fourth transfer gates, detects coincidence between said storage data and retrieval data in correspondence with control of a coincidence-detection control signal, and outputs bit-data coincidence-detection information; and
a second number of word blocks, arranged in a column direction, each having a word-data coincidence detector, including said plurality of associated memories arranged in a row direction, which integrates said bit-data coincidence-detection information in word units and outputs word-data coincidence-detection information,
wherein said word-data coincidence detector includes:
a transfer gate group having said first number of serially-connected fifth transfer gates, each having a control gate to input said first number of bit-data coincidence-detection information of said word-data coincidence detectors, and one end connected to a first potential, wherein each of said transfer gates outputs said word-data coincidence-detection information; and
switch circuits which connect or disconnect another end of each of said transfer gate with a second potential, in correspondence with control of said coincidence-detection control signal.

2. The associative memory according to claim 1, wherein each of said first to fifth transfer gates and said switch circuits comprise a single MOS transistor.

3. The associative memory according to claim 1, wherein said bit-data coincidence detector serially connects said third and fourth transfer gates, connects the one ends of said third and fourth transfer gates to respective complementary retrieval data-bit lines, connects the respective first and second terminals of said memory device to control gates of said third and fourth transfer gates, and outputs said bit-data coincidence-detection information from a common connection point of said serially-connected third and fourth gates.

4. The associative memory according to claim 1, wherein said bit-data coincidence detector connects said respective control gates of said third and fourth transfer gates to complementary retrieval data-bit lines, connects said first and second terminals of said memory device to one ends of said third and fourth transfer gates, and commonly connects the other ends of said third and fourth transfer gates, and outputs said bit-data coincidence information.

5. The associative memory according to claim 3, wherein said third and fourth transfer gates are complementary transfer gates which respectively parallel-connect an N-channel MOS (Metal Oxide Semiconductor) transistor and a P-channel MOS transistor, connect said respective first and second terminals of said memory device to respective gates of the N-channel MOS transistors of said third and fourth transfer gates, connect said respective first and second terminals of said memory device to respective gates of the P-channel MOS transistors of said third and fourth transfer gates.

6. The associative memory according to claim 3, wherein said third and fourth transfer gates are complementary transfer gates which respectively parallel-connect an N-channel MOS transistor and a P-channel MOS transistor, connect said respective complementary retrieval data-bit lines to respective gates of the N-channel MOS transistors of said third and fourth transfer gates, and connect said respective complementary retrieval data-bit lines to respective gates of the P-channel MOS transistors of said third and fourth transfer gates.
